# EUROPÄISCHE PATENTSCHRIFT

(11) **EP 2 191 542 B1**
(45) Veröffentlichungstag und Bekanntmachung des Hinweises auf die Patenterteilung: **28.11.2012**
(21) Anmeldenummer: 08801064.0
(22) Anmeldetag: 24.07.2008
(51) Int. Cl.: H01R 13/66, H01R 13/46, H01R 13/631

(54) **IDENTIFIZIERBARES KABEL**
IDENTIFIABLE CABLE
CÂBLE IDENTIFIABLE

(30) Priorität: 20.08.2007 DE 202007011630 U; 28.01.2008 DE 202008001256 U
(43) Veröffentlichungstag der Anmeldung: 02.06.2010
(73) Patentinhaber: Zellner GmbH, 94234 Viechtach (DE)
(72) Erfinder: KLEES, Ernst, 80939 München (DE)
(74) Vertreter: Neidl-Stippler, Cornelia
(86) Internationale Anmeldenummer: PCT/DE2008/001224
(87) Internationale Veröffentlichungsnummer: WO 2009/024114

(56) Entgegenhaltungen:
- JP-A- 5 250 077
- US-A1- 2006 232 385
- US-B1- 6 577 243
- US-B1- 7 038 135

## Beschreibung

Die Erfindung betrifft ein Kabel mit mindestens 2 identifizierbaren Steckelementen, insbesondere ein Patchkabel, dessen beide Enden detektierbar sind sowie ein Verfahren zur Kabelidentifikation

Die Verfolgung von Kabeln über weite Strecken und Zuordnung der Kabelenden zueinander ist bei Mehrfachanschlüssen, wie Patchfeldern, schwierig. Es werden zwar Farbcodierungen eingesetzt, anhand derer Kabel unterscheidbar sind, diese sind aber aufgrund einer eingeschränkten Farbwahl begrenzt, bei schlechter Beleuchtung unzureichend und für Farbenblinde nicht lesbar. Es wurden auch bereits Stecker mit RFIDs vorgesehen, die dann über ein entsprechendes Lesegerät aufwendig ausgelesen werden müssen - dies ist für einfache Verdrahtungen zu aufwändig und erfordert Spezialgerät, das nicht immer vorhanden ist. Ferner sind Kabel mit Verfolgungsmöglichkeit gepatchter Anschlüsse bekannt, die eine parallel zum Adernbündel verlaufende Kunststoff-Lichtwellenleiter-Faser umfassen. Mit einer externen Lichtquelle, die auf ein Ende des Patchkabels aufgesteckt wird, kann das zum Kabel zuzuordnende Kabelende festgestellt werden, denn nach Durchlaufen der Kunststoff-Lichtwellenleiter-Faser tritt das Licht am anderen Ende des bekannten Patchkabels leuchtpunktförmig aus.

Das bekannte Patchkabel mit Kunststoff-Lichtwellenleiter-Faser-basierter Identifizierungseinrichtung ist verbesserungsfähig:
- es fordert wegen der Integration der Lichtwellenleiter-Faser in das Patchkabel aufwendig herzustellende und teure Spezialkabel .
- die Lichtleistung beim Lichtaustritt an den zu detektierenden Kabelenden oftmals schwach, insbesondere bei Dämpfung der Lichtleistung während des Weges durch die Kunststoff-Lichtwellenleiter-Faser aufgrund der Länge des Patchkabels oder aufgrund dessen Krümmung.
- Lichtwellenleiter sind empfindlich, können bei starkem Knicken oder Druck brechen;
- die Detektierbarkeit des zu detektierenden Kabelendes ist aufgrund der kleinen Leuchtfläche schlecht. Falls eine Laserlichtquelle an einem Ende des bekannten Patchkabels angeschlossen wird, um das andere Ende des bekannten Patchkabels durch das Laserlicht zum punktförmigen Aufleuchten zu veranlassen, ist eine Gefährdung durch die Laserstrahlung gegeben
- integrierte Kunststoff-Lichtwellenleiter-Fasern sind aufwändig, zeitraubend, mühsam, umständlich, mit besonders zahlreichen Arbeitsschritten und besonders kostenintensiv installierbar.

Patchkabel nach dem Stanol der Technik sind aus US-A-6577243 und US-A-7038135 bekannt.

Aufgabe der vorliegenden Erfindung ist daher die Bereitstellung eines Kabels, das die Nachteile des Standes der Technik vermeidet.

Erfindungsgemäss wird diese Aufgabe durch ein Kabel mit den Merkmalen des Patentanspruches 1 gelöst. Ferner bezieht sich die Erfindung auch auf ein Verfahren zur Identifikation des mindestens einen Endes einer installierten Leitung, mit: Vorlegen eines Kabels mit: mindestens einer elektrischen Prüfleitung; mindestens einem Anzeigeelement an einem Steckerelement am Kabelende; mindestens einem Aktivierungselement am Steckerelement am Kabelende zur Energieeinspeisung in die elektrische Prüfleitung; Energieversorgung des Anzeigeelementes des zu identifizierenden Kabelelementes über Energieeinspeisung in die elektrische Prüfleitung durch ein Aktivierungelement unter Aktivierung der Anzeige am Steckelement; und Identifikation des zum Kabel gehörigen Steckelements anhand der Anzeige

Dadurch, daß nun herkömmliche, kostengünstiger Kabel mit elektrischen Leitern ohne teure Integration einer kostenintensiven Kunststoff-Lichtwellenleiter-Faser eingesetzt werden, wobei die Signalstärke durch diese am zu detektierenden Kabelende groß und von der Länge des Kabels und von Krümmungen des Kabels im wesentlichen unabhängig ist und keine Dämpfung erfährt, ist eine hervorragende, stets in hervorragendem Ausmasse wahrnehmbare Detektierbarkeit sichergestellt, wobei die Montage des Kabels einfach, schnell, mühelos, irrtumssicher und nur eine geringe Anzahl von Arbeitsschritten erfordernd und folglich besonders kostengünstig ist.

Besonders bevorzugte Ausführungsformen sind Gegenstand der abhängigen Ansprüche.

Die Erfindung bezieht sich auch auf Kabel, bei denen das Steckelement ein mindestens einpoliger Stecker oder Buchse ist und zur elektrisch leitenden Verbindung oder zum elektrisch leitenden Anschluss des Kabels an eine Verkabelung und/oder an ein Gerät und/oder an eine Vorrichtung zur Übertragung von Signalen, dient. Die internen steckelementwärtigen elektrischen Energiequellen können bspw. Batterien, Akkumulatoren oder Kondensatoren sind.

Am Steckelement-Gehäuse kann ein Rastzungenschutz vorgesehen sein, wobei mindestens ein Signalgeber neben dem Ansatz des Rastzungenschutzes am Gehäuse liegt.

Dabei kann es sinnvoll sein daß der Rastzungenschutz ein vollständig oder teilweise lichtdurchlässiges oder opal oder opak oder opaleszierend oder transparent oder eine Lichtstreuung oder eine Lichtreflexion bewirkendes Material umfasst.

Am Steckergehäuseabschnitt kann mindestens ein elektrischer Kontakt vorgesehen sein, über den eine externe Stromversorgung reversibel anschliessbar ist und gehäuseinnenseitig der mindestens einem Kontakt mit dem Signalgeber eines anderen Steckelementes elektrisch leitend verbunden ist.

Die elektrisch leitenden Kontakte des einen Steckelementes zum reversiblen anschluß einer externen Stromquelle stehen gehäuseinnenseitig zusätzlich mit dem oder den optoelektronischen Signalgebern 5, 6 des anderen Steckelementes 4, 9 über mind. einen kabelinternen Prüfdraht 21 und/oder die Kabelabschirmung 22 elektrisch leitend in Verbindung steht.

Dabei kann die mindestens eine elektrische Leitung 7, 21, 22 mindestens einen kabelinternen Prüfdraht 21 oder Kabelabschirmung 22 aufweist.

Geeignete Signalgeber können sein : Glühbirnen, Leuchtdioden, Light Emitting Diodes LED's oder Lumineszenz-Dioden, die bei Stromversorgung Licht - bspw. im sichtbaren Wellenlängenbereich, aber auch Infrarot- oder Ultraviolettstrahlung abstrahlen können.

Es kann auch vorgesehen sein, dass an mindestens einem Steckelement mindestens eine darin integrierte Strom/oder Spannungsquelle zur Einspeisung von elektrischer Energie aus einer kabel-internen Quelle in die elektrisch leitende Verbindung vorliegt.

Bei in zwei Steckelemente integrierten, kabelinternen Energiequellen kann jedes Steckelement einen oder mehrere in den Stromkreis integrierte elektrische Schalter umfassen. Bspw. können die Steckelement Schalter ausgewählt sein aus der Gruppe bestehend aus: Tastschalter, verrastende Tastschalter, Magnetschalter, Relaisschalter, Kipphebelschalter, um federnde Rastzungen oder um federnde Rastzungenschutzeinrichtungen.

Die externe oder interne Energieversorgung in die elektrisch leitende Verbindung kann kontinuierlich oder getaktet sein.

Schließlich kann das Steckelement ein mindestens einpoliger Stecker oder Buchse sein und zur elektrisch leitenden Verbindung oder zum elektrisch leitenden Anschluss des Kabels an eine Verkabelung und/oder an ein Gerät und/oder an eine Vorrichtung zur Übertragung von Signalen, dienen.

Die internen Steckelement-Energiequellen können bspw. Batterien, Akkumulatoren oder Kondensatoren sein - sie können aber auch durch reine Induktion mit Energie versorgt werden.

Zusammenfassend ist festzustellen, dass im Rahmen der vorliegenden Erfindung ein Kabel, bspw. ein Datenkabel oder Patchkabel, bereitgestellt wird, welches eine Einrichtung zum Identifizieren, Detektieren und Auffinden der beiden Enden des Kabels umfasst, wobei erstmals der Einsatz herkömmlicher, kostengünstiger elektrisch leitfähiger Adern möglich ist und auf eine aufwendige Integration einer empfindlichen, kostenintensiven Kunststoff-Lichtwellenleiter-Faser verzichtet werden kann.

Ein weiterer Vorteil des erfindungsgemässen Kabels besteht darin, dass die Signalstärke an den Kabelenden gross und von der Länge des Kabellänge und Kabelkrümmungsradius im wesentlichen unabhängig ist. Insbesondere wird die Signalstärke der Detektions- und Identifizierungseinrichtung des erfindungsgemässen Kabels nur sehr wenig durch die Länge oder Krümmungen des Kabels gedämpft. Das erfindungsgemässe Kabel ermöglicht für das mindestens eine zu detektierende Kabelende eine hervorragende, stets gut wahrnehmbare Detektierbarkeit u.a. wegen einer - ggf. grossen - beleuchteten Oberfläche des Steckelements oder des Steckergehäuses.

Auch die von einer Laserquelle - wie bei dem bekannten Kabel mit Lichtwellenleiter, der über eine Laserquelle gespeist wird - grundsätzlich ausgehende Unfallgefahr wird durch Einsatz einer elektrisch leitenden Verbindung - anstelle eines optisch leitenden Lichtwellenleiters - zwischen den Signalgebern, vermieden.

Ein weiterer Vorteil des erfindungsgemässen Kabels ist dessen besonders einfache, schnelle, müheloser, irrtumssichere und nur wenige Arbeitsschritte erfordernde und folglich besonders kostengünstige Montage.

Eine besonders günstige Herstellbarkeit des erfindungsgemässen Kabels ergibt sich insbesondere daraus, dass jedes Steckelement, und bevorzugt auch die Gehäuse der Steckelemente aus einzelnen Modulen (z. B. 20) zusammengesetzt werden. Diese Module (z. B. 20) können ohne grossen Aufwand vorkonfektioniert zur Endmontage angeliefert werden.

Darüber hinaus findet beim erfindungsgemässen Kabel keine störungsanfällige Vermischung von elektrisch leitenden und optisch leitenden Komponenten statt. Bei bevorzugten Ausführungsformen des erfindungsgemässen Kabels kann das Steckelement in Form bspw. eines ein- oder mehrpoligen Steckers oder bspw. in Form einer ein- oder mehrpoligen Buchse ausgebildet sein.

Häufig dienen die Steckelemente zur elektrisch leitenden Verbindung oder zum elektrischen Anschluss des Kabels mit oder an eine Verkabelung und/oder an ein Gerät und/oder an eine Vorrichtung zur Übertragung von Signalen oder aber auch zum Anschluß an Patchfeldern.

In bevorzugten Ausführungsformen des erfindungsgemässen Kabels ist der Signalgeber optoelektronisch. Selbstverständlich kann der Signalgeber aber auch bspw. in Form eines Summers, eines Piezo-Lautsprechers oder einer Vibrationen erzeugenden Einrichtung oder Kombinationen davon, vorliegen.

Die elektrisch leitende Verbindung umfaßt an sich bekanntes, dem Fachmann offensichtliches, elektrisch leitfähiges Material, wie ein oder mehrere Metalle, Kupfer, Silber, Gold, Platin oder einen elektrisch leitfähigen Kunststoff, oder Mischungen hiervon.

Meist kann es sich bei der externen Stromquelle zur Stromversorgung der elektrischen Signalleitung über die steckelementwärtigen Einrichtungen zur Energieversorgung um eine Batterie, einen Akkumulator, einen Kondensator, um einen mit dem Stromnetz verbundenen Transformator oder um eine Kombination hiervon handeln.

Bei anderen Ausführungsformen des erfindungsgemässen Kabels können die internen steckelementwärtigen elektrischen Energiequellen Batterien, Akkumulatoren oder Kondensatoren sein, wobei ein Taktgeber in den Stromkreis integrierbar sein kann.

Meist erfolgt die Einspeisung von elektrischer Energie in die Signalleitung über eine Strom- und/oder Spannungsquelle. Diese kann eine konstant Strom bereitstellende Stromquelle sein. Die elektrische Energie kann aber auch induktiv zugeführt werden

Bei Ausführungsformen des erfindungsgemässen Kabels können die Steckelementgehäuse zumindest teilweise - zur Vergrösserung der leuchtenden Detektionsfläche und damit zur Verbesserung der Detektierbarkeit der kabelendwärtigen Steckelemente lichtleitend, transparent, opak, opal, fluoreszierend und/oder eingefärbt ausgebildet sein.

Bevorzugt stehen die Gehäuse der Steckelemente dann optisch leitend mit den dann bevorzugt optoelektronischen Signalgebern vollständig oder abschnittsweise in Verbindung.

Ggf. können die Signalgeber von den kabelendwärtigen Steckelementen zumindest etwas räumlich beabstandet und davon getrennt vorgesehen sein. Die Signalgeber können parallel oder in Reihe geschaltet sein.

Besonders vorteilhaft ist das erfindungsgemässe Kabel mit einem in das jeweilige Steckelement direkt integrierten optoelektronischen Signalgeber gegenüber solchen Kabeln, bei denen die Signalgeber von den jeweils endwärtigen Steckelementen zumindest etwas beabstandet vorgesehen sind, weil keine nachteilige Beeinflussung der Erkennbarkeit durch gebogene Verbindungskabel

Nachfolgend wird die Erfindung anhand von Ausführungsbeispielen auf die sie keineswegs eingeschränkt ist, sowie anhand der begleitenden Zeichnungen näher erläutert. Es zeigen:
Fig. 1 eine schematische, perspektivische Ansicht eines erfindungsgemässen Steckelementes mit beleuchtbarem Rastzungenschutz;
Fig. 2 eine schematische perspektivische Ansicht eines eine beleuchtbare Rastzunge tragenden Steckelement-Gehäuse-Abschnittes,
Fig. 3 eine weitere schematische perspektivische Ansicht des Gehäuseabschnitts der Fig. 2
Fig. 4 eine, schematische, perspektivische und teilweise geschnittene Teilansicht des in Fig. 1 dargestellten Steckelementes,
Fig. 5 eine schematische, perspektivische Seitenansicht des in den Fig. 1 und Fig. 4 dargestellten Steckelementes mit angeschlossener externer Stromquelle
Fig. 6 eine schematische, teilweise geschnittene Ansicht eines Kabels mit Steckelementen an seinen Enden; und
Fig. 7 eine schematische, teilweise geschnittene Ansicht des Kabels einer weiteren

Ausführungform mit in beide Steckelemente integrierten Strom und/oder Spannungsquellen und Schaltern.

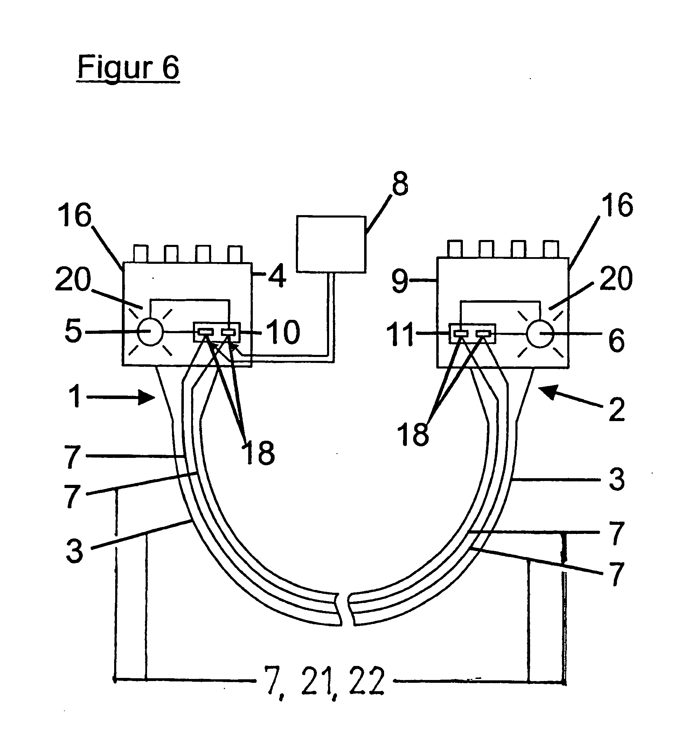

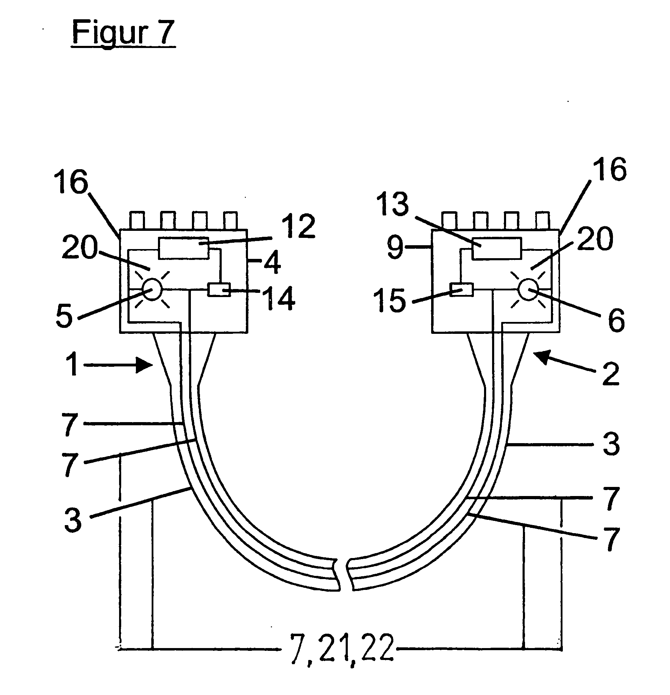

Wie in Figur 6 und 7 gezeigt, umfaßt ein Kabel 3 zur optoelektronischen Identifizierbarkeit und Detektierbarkeit seiner beiden Endabschnitte 1, 2 an jedem Kabelendabschnitt 1, 2 jeweils ein Steckelement 4, 9. Jedes Steckelement 4, 9 besitzt optoelektronische Signalgeber 5, 6. Die optoelektronischen Signalgeber 5, 6 sind über Leitungen 7, 21, 22 verbunden.

Daher sind bei Einspeisung von elektrischer Energie in die elektrische Leitung 7, 21, 22 die optoelektronischen Signalgeber 5, 6 der beiden Kabelendabschnitte 1, 2 - zur Identifizierung und Detektierung der zu demselben Kabel 3 gehörenden Kabelendabschnitte 1, 2 und der zu demselben Kabel 3 gehörenden, endwärtigen Steckelemente 4, 9 aktivierbar. Bei der in den Fig. 6 und 7 dargestellten Ausführungsformen sind die optoelektronischen Signalgeber 5, 6 direkt in den Gehäusen 16 der gegenüberliegenden Steckelemente 4, 9 vorgesehen.

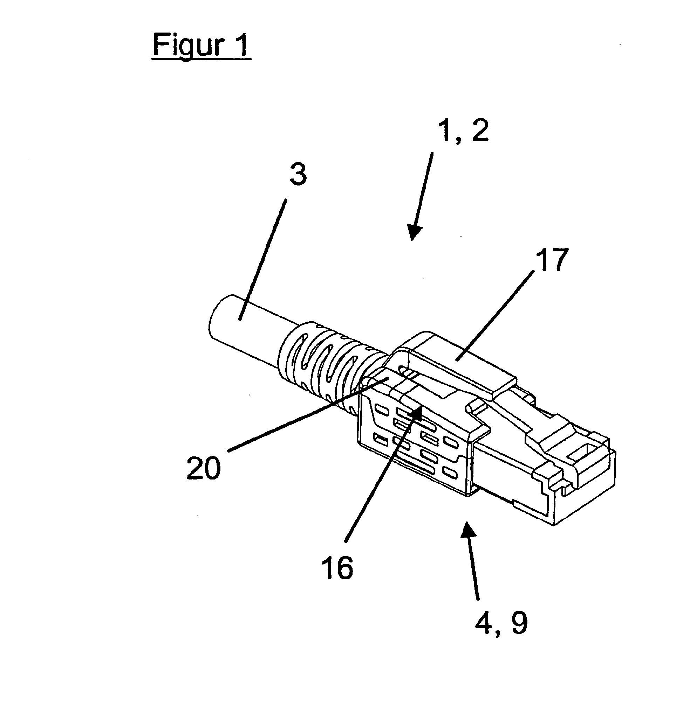

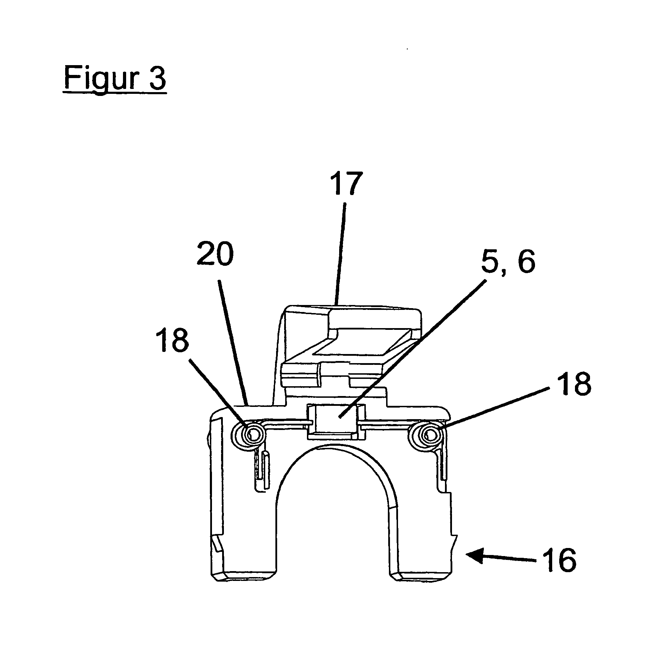

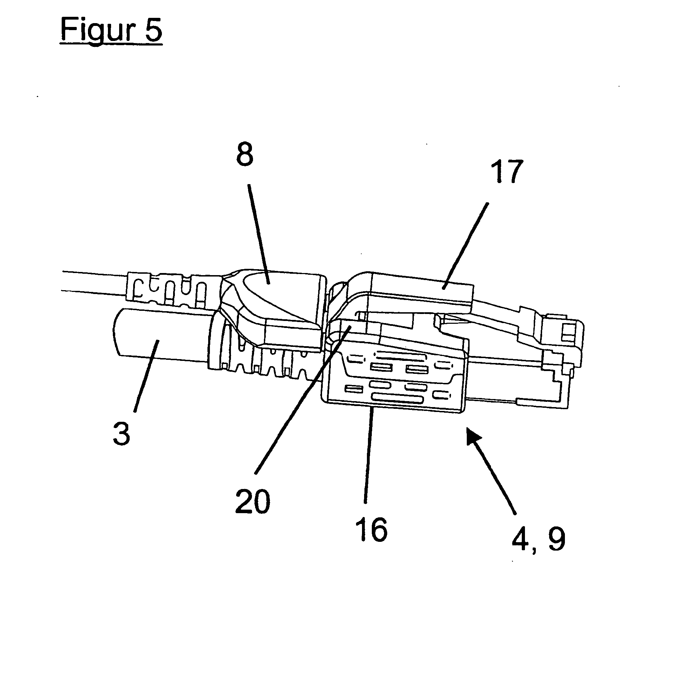

In Fig. 1 - 5 sind Steckergehäuse 16 bzw. Teile davon dargestellt, wie sie erfindungsgemäß eingesetzt werden können.

Es ist eine Ausführungsform mit beleuchtbarem Rastzungenschutz und optischer Anzeige 5,6 gezeigt, auf welche die Erfindung allerdings keineswegs eingeschränkt ist. Wie insbesondere aus den Fig. 1, Fig. 2, Fig. 3, Fig. 4 und Fig. 5 hervorgeht, ist am Steckergehäuse 16 ein Rastzungenschutz 17 nahe eines optischen Signalgebers 5, 6 vorgesehen.

Meist ist mindestens ein optoelektronischer Signalgeber 5, 6 in dem Gehäuseabschnitt 20 vorgesehen, der dem Ansatz des Rastzungenschutzes 17 an dem Gehäuse 16 benachbart ist. Bevorzugt umfasst der Rastzungenschutz 17 ein Material, welches zumindest teilweise lichtdurchlässig oder opal oder opak oder opaleszierend oder transparent oder eine Lichtstreuung oder eine Lichtreflexion oder Fluoreszenz bewirkend, ist.

Die optische Anzeige 5,6 befindet sich bei der dargestellten Ausführungsform unter dem Rastzungenschutz 17, sodaß der Lichtaustritt über den transparenten Rastzungenschutz erfolgt, welcher das Licht ggf. streuen, transformieren (bspw. durch Fluoreszenz) oder aber durchlassen kann.

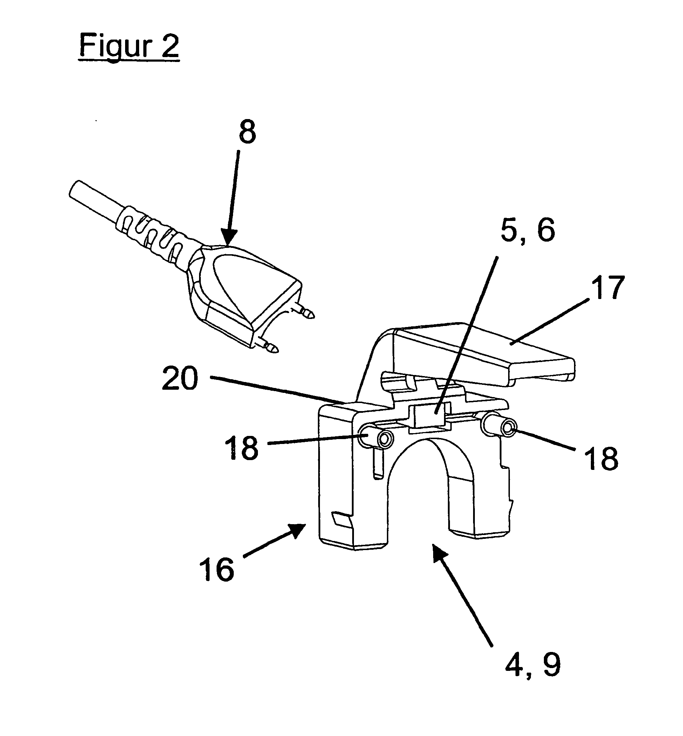

Wie in Fig. 2, Fig. 3, Fig. 4 und Fig. 5 gezeigt, sind am Gehäuseabschnitt 20 des Steckelementes 4 , an dem der Rastzungenschutz 17 ansetzt, ein oder mehrere elektrisch leitende Kontakte 18 vorgesehen. Insbesondere Fig. 2, Fig. 5 und Fig. 6 zeigen die reversible Anschlußmöglichkeit einer externen Stromversorgung 8 an die Kontakte 18 . Im Gehäuse 20 sind die Kontakte 18 zumindest mit dem optoelektronischen Signalgeber 5, 6 des jeweiligen Steckelementes 4, 9 über die elektrische Signalleitung verbunden.

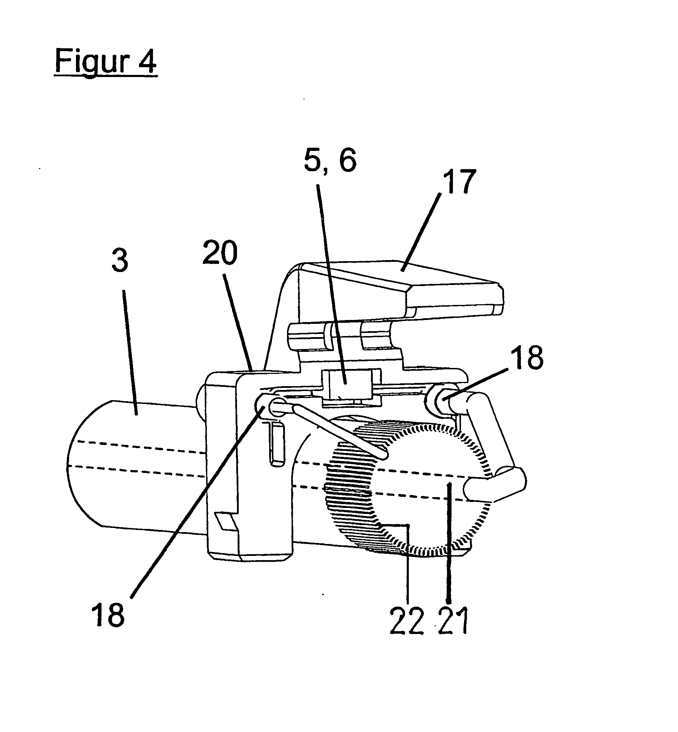

Fig. 4 und Fig. 6 zeigen, dass die elektrisch leitenden Kontakte 18 des einen Steckelementes 4, 9 über einen oder mehrere kabelinterne Prüfdrähte 21 und/oder über die Kabelabschirmung 22, elektrisch verbunden sein können.

Die mindestens eine elektrische Signalleitung 7, 21, 22 zur Verbindung der Signalgeber 5, 6 gegenüberliegender Steckelemente 4, 9 ist in Fig. 4 ein kabelinterner Prüfdraht 21.

Das Gehäuse 16 jedes Steckelementes 4, 9 ist bevorzugt - wie insbesondere in den Fig. 1, Fig. 4 und Fig. 5 dargestellt - modular - damit mehrteilig.

Die optoelektronischen Signalgeber 5, 6 können Glühbirnen, Leuchtdioden, Light Emitting Diodes (LED's) oder Lumineszenz-Dioden sein, die bei Stromversorgung Licht im sichtbaren Wellenlängenbereich, Infrarotstrahlung oder Ultraviolettstrahlung emittieren.

Wie aus Fig. 2, Fig. 5 und Fig. 6 ersichtlich, kann jedes Steckelement 4, 9 eine oder mehrere Einrichtungen 10, 11; 18 zur Einspeisung von aus einer externen Stromquelle 8 oder Spannungsquelle stammender elektrischer Energie in die elektrisch leitende Verbindung 7, 21, 22 umfassen.

Insbesondere Fig. 7 zeigt, dass jedes Steckelement 4, 9 eine oder mehrere darin integrierte Stromquellen oder Spannungsquellen 12, 13 zur Versorgung mit aus einer kabelinternen Stromquelle oder Spannungsquelle 12, 13 stammenden elektrischen Energie in die elektrisch leitende Verbindung 7, 21, 22 umfassen kann. Fig. 7 zeigt auch, dass insbesondere bei in beide Steckelemente 4, 9 integrierten, kabelinternen Stromquellen oder Spannungsquellen 12, 13 jedes Steckelement 4, 9 ein oder mehrere elektrische Schalter 14, 15 umfassen kann, die bevorzugt in den Stromkreis integriert sind.

Die Steckelement Schalter 14, 15 können bspw. Tastschalter, verrastende Tastschalter, Magnetschalter, Relaisschalter, Kipphebelschalter, federnde Rastzungen oder federnde Rastzungenschutzeinrichtungen, umfassen.

Die Einspeisung der elektrischen Energie in die elektrisch leitende Verbindung 7, 21, 22 kann in Abhängigkeit von der Einsatzsituation kontinuierlich oder getaktet erfolgen.

Das Kabel 3 kann bspw. eine elektrische Verbindungsleitung, eine elektrische Datenverbindungsleitung, eine Energieversorgungsleitung, ein Datenanschlusskabel, Patchkabel oder eine Kombination hiervon sein.

Bei der Zuordnung von Kabelsteckern, die in einem Patchfeld fest installiert sind und uminstalliert werden sollen, kann bei der Ausführungsform der Fig.6 erfindungsgemäß so vorgegangen werden. Am Kabelende 5 wird über die Stromeinspeisung 10 eine externe Stromversorgung 8 an die Signalleitungen 7 angeschlossen. Aufgrund der Energieversorgung leuchten nun die Leuchtdioden 5 und 6, die über diese Signalleitungen 7 verbunden sind, auf. Es wird nun ersichtlich, welcher Stekker im Patchfeld zum Kabel gehört, dessen Stromversorgung 8 aktiviert wurde.

Bei Ausführungsformen, wie sie schematisch in Fig. 7 dargestellt sind, wird anstelle der Stromeinspeisung eine Stromquelle mittels eines Schalters 14,15 am jeweiligen Stecker mit der optischen Anzeige 5, 6 verbunden, wodurch dann diese Anzeige aktiviert wird und leuchtet.

Während verschiedene Ausführungsformen der Erfindung detailliert beschrieben wurden, sind dem Fachmann, an den sich diese Erfindung wendet, alternative Ausführungsformen und Auslegungen zur Durchführung der Erfindung offensichtlich. Die oben beschriebene Ausführungsformen sollen nur die Erfindung erläutern, die innerhalb des Umfangs der nachfolgenden Ansprüche modifiziert werden kann.

### Bezugszeichenliste

- 1: Kabelendabschnitt
- 2: Kabelendabschnitt
- 3: Kabel
- 4: Steckelement an 3
- 5: Signalgeber an 4.
- 6: Signalgeber an 9.
- 7: elektrische Leitung
- 8: externe Stromversorgung
- 9: Steckelement
- 10: Stromeinspeisung
- 11: Stromeinspeisungseinrichtung
- 12: externe/ integrierte Strom/Spannungsquelle
- 13: externe/integrierte Strom/Spannungsquelle
- 14: elektrische Schalter
- 15: elektrische Schalter
- 16: Steckergehäuse
- 17: Rastzungenschutz von 16
- 18: elektrischer Kontakt an 20
- 20: Stecker-Gehäuseabschnitt von 16 mit Rastzungenschutz 17
- 21: Prüfdraht
- 22: Kabelabschirmung.

## Patentansprüche

1. Kabel (3) mit mindestens zwei identifizierbaren Steckelementen an den Kabelenden (1,2), wobei:
mindestens ein Steckelement (4, 9) mindestens einen Signalgeber (5, 6) aufweist:
der Signalgeber (5, 6) über mindestens eine elektrische Signal-Leitung (21, 22) im Kabel (3) mit mindestens einem weiteren Steckelement (9,4) am anderen Kabelende verbunden ist, und
das Steckelement ein Steckelement-Gehäuse (16) aufweist, das einen Steckelement-Gehäuseabschnitt (20) mit mindestens einem Signalgeber (5, 6) besitzt, so dass bei Energieeinspeisung in die elektrische Signalleitung (21, 22) an einem Steckelement mindestens ein Signalgeber (5, 6) an einem weiteren Steckelement aktivierbarist, **dadurch gekennzeichnet, dass**
der Steckelement-Gehäuseabschnitt (20) einen Rastzungenschutz (17) aufweist, der Signalgeber (5) ein optoelektronischer Signalgeber nahe des Rastzungenschutzes (17) ist und der Rastzungenschutz (17) und das Steckelementgehäuse zumindest teilweise - zur Vergrösserung der leuchtenden Detektionsfläche und
damit zur Verbesserung der Detektierbarkeit der kabelendwärtigen Steckelemente lichtleitend, oder transparent, oder opak, oder opal, oder fluoreszierend ausgebildet sind und mit den optoelektronischen Signalgebern vollständig oder abschnittsweise optich leitend in Verbindung stehen.

2. Kabel (3) Anspruch 1, **dadurch gekennzeichnet, dass** am Gehäuseabschnitt (20) mindestens ein elektrischer Kontakt (18) vorgesehen ist, über den eine externe Stromversorgung (8) reversibel anschliessbar ist, der gehäuseinnenseitig mit dem optoelektronischen Signalgeber (5, 6) eines anderen Steckelementes (4, 9) elektrisch verbunden ist.

3. Kabel (3) nach Anspruch 2, **dadurch gekennzeichnet, dass** die elektrisch leitenden Kontakte (18) des einen Steckelementes (4, 9), gehäuseinnenseitig mit dem oder den opto-elektronischen Signalgebern (5, 6) des anderen Steckelementes (4, 9) über mindestens eine kabelinterne Signalleitung elektrisch leitend in Verbindung stehen.

4. Kabel (3) nach einem der vorhergehenden Ansprüche, **dadurch gekennzeichnet, dass** die mindestens eine elektrische Signalleitung (7, 21, 22) mindestens einen kabelinternen Prüfdraht (21) oder Kabelabschirmung (22) aufweist.

5. Kabel (3) nach einem der vorhergehenden Ansprüche, **dadurch gekennzeichnet, dass** die optoelektronischen Signalgeber (5, 6) ausgewählt sind aus der Gruppe bestehend aus Leuchtdioden, Light Emitting Diodes (LED's) oder Lumineszenz-Dioden, die bei Stromversorgung im sichtbaren Wellenlängenbereich, Infrarotstrahlung oder Ultraviolettstrahlung abstrahlen.

6. Kabel (3) nach einem der vorhergehenden Ansprüche, **dadurch gekennzeichnet, dass** an mindestens einem Steckelement (4, 9) mindestens eine darin integrierte Strom/oder Spannungsquelle (12, 13) zur Einspeisung von elektrischer Energie aus einer kabel-internen Quelle (12, 13) in die elektrische Signalleitung (21, 22) vorliegt.

7. Kabel (3) nach Anspruch 6, **dadurch gekennzeichnet, dass** bei im Steckelement (4, 9) integrierten, kabelinternen Energiequellen (12, 13) jedes Steckelement (4, 9) mindestens einen in den Stromkreis integrierten elektrische Schalter (14, 15) umfasst.

8. Kabel (3) nach Anspruch 7, **dadurch gekennzeichnet, dass** die Steckelement Schalter (14, 15) ausgewählt sind aus der Gruppe bestehend aus: Tastschalter, verrastende Tastschalter, Magnetschalter, Relaisschalter, Kipphebelschalter, federnde Rastzungen oder federnde Rastzungenschutzeinrichtungen.

9. Kabel (3) nach einem der vorhergehenden Ansprüche, **dadurch gekennzeichnet, daß** die Energieversorgung in die elektrische Signalleitung (21, 22) kontinuierlich oder getaktet ist.

10. Kabel (3) nach einem der vorhergehenden Ansprüche, **dadurch gekennzeichnet, dass** das mindestens eine Steckelement (4, 9) ein mindestens einpoliger Stecker oder Buchse für die elektrische Verbindung oder Anschluss des Kabels (3) an eine Verkabelung und/oder an ein Gerät und/oder an eine Vorrichtung zur Übertragung von Signalen, ist.

11. Kabel (3) nach einem der vorhergehenden Ansprüche, **dadurch gekennzeichnet, dass** die internen Steckelement- Energiequellen (12, 13) ausgewählt sind aus Batterien, Akkumulatoren oder Kondensatoren.

12. Verfahren zur Identifikation von Steckelementen einer Leitung, **gekennzeichnet durch**:
- Vorlegen eines Kabels nach einem der vorangehenden Ansprüche mit:
mindestens einer elektrischen Prüfleitung;
mindestens einem Anzeigeelement an einem Steckerelement am Kabelende, das an einen opaken Kabelgehäuseabschnitt gekoppelt ist; und
mindestens einem Aktivierungselement am Steckerelement am Kabelende zur Energieeinspeisung in die elektrische Prüfleitung;
- Energieversorgung des Anzeigeelementes des zu identifizierenden Kabelelementes über Energieeinspeisung in die elektrische Prüfleitung **durch** ein Aktivierungelement unter Aktivierung der Anzeige am Steckelements und einer beleuchteten Oberfläche des Steckergehäuses ; und
- Identifikation des zum Kabel gehörigen Steckelements anhand der Anzeige.

## Claims

1. Cable with at least two identifiable plug-in elements at the cable ends (1, 2), wherein at least one plug-in element (4, 9) has a signal emitter (5, 6) : the signal emitter (5, 6) being connected with at least one more plug-in element (9, 4) at the other cable end over a signaling line (21, 22) in the cable, and the plug-in element being equipped with a plug-in element casing (16) which has a plus-in element casing section (20) with at least one signal emitter (5, 6), so that one signal emitter (5, 6) on one plug-in element may be activated from another plug-in element at the moment of supplying power in the electrical signaling line (21, 22), **characterized in that** the plug-in element casing section (20) has a protection tab (17), the signal emitter is an optoelectronic signal emitter near the protection tab (17), and the protection tab (17), along with the plug-in element casing, at least partially, is configured for the enlargement of the glowing detection surface and, for the improvement of the detectability of the plug-in element at the end of the cable, either light conducting, transparent, opaque, opal or fluorescent, and in completely or partially optically conducting connection to the optoelectronic signal emitters.

2. Cable (3) according to claim 1, **characterized in that** the casing section (20) has at least one electrical contact (18), over which an outer current supply (8) can be reversibly connected, and which is electrically connected, inside the casing, with the optoelectronic signal emitter (5, 6) from another plug-in element (4, 9).

3. Cable (3) according to claim 2, **characterized in that** the electrically conducting contact (18) of the one plug-in element (4, 9) has an electrically conducting connection inside the casing to the optoelectronic signal emitter (5, 6) of the other plug-in element (4, 9) over at least one signaling line inside the cable.

4. Cable (3) according to any of the preceding claims, **characterized in that** the at least one electrical signaling line (7, 21, 22) has at least one test wire (21) inside the cable or a cable shield (22).

5. Cable (3) according to any of the preceding claims, **characterized in that** the optoelectronic signal emitters (5, 6) are chosen amongst a group of light emitting diodes from which, at the moment of supplying power in the visible wavelength range, emanate infrared or ultraviolet rays.

6. Cable (3) according to any of the preceding claims, **characterized in that** on at least one plug-in element (4, 9), at least one current/tension source (12, 13) is integrated for supplying electrical energy from a source inside the cable (12, 13) to the electrical signaling line (21, 22).

7. Cable (3) according to claim 6, **characterized in that**, for the energy sources inside the cable (12, 13) integrated to the plug-in element (4, 9), every plug-in element (4, 9) includes at least one switch integrated in the electric circuit (14, 15).

8. Cable (3) according to claim 7, **characterized in that** the plug-in element switch (14, 15) is chosen from amongst a group of: press-switches, blocking press-switches, magnetic switches, relay switches, toggle switch, springy tabs or other springy protection tab devices.

9. Cable (3) according to any of the preceding claims, **characterized in that** the power supply in the electrical signaling line (21, 22) is either continuous or clocked.

10. Cable (3) according to any of the previous claims, **characterized in that** the at least one plug-in element (4, 9) is an at least unipolar plug or socket for the electrical connection of the cable (3) to a cabling and/or a device and/or an instrument for the transmission of signals.

11. Cable (3) according to any of the previous claims, **characterized in that** the internal energy sources of the plug-in elements (12, 13) are chosen amongst batteries, accumulators or condensers.

12. Method for the identification of plug-in elements in a circuit, **characterized by** :
- placement of a cable according to any of the preceding claims with :
at least one electrical test wire;
at least one indicating element on a plug-in element at the cable end, which is connected to an opaque cable casing section; and
at least one activation element on the plug-in element at the cable end for the power supply in the electrical test circuit;
- Power supply of the indicating element of the cable element to be identified over the power supply in the electrical test circuit through an activation element after the activation of the display on the plug-in element and of a glowing surface area of the plug casing; and
- Identification of the plug-in elements belonging to the cable with the help of the display.

## Revendications

1. Câble (3) avec au moins deux éléments enfichables identifiables situés aux extrémités des câbles (1, 2), dont au moins un des éléments enfichables (9, 4) est doté d'un émetteur de signal (5, 6) : l'émetteur de signal (5, 6) étant connecté avec au moins un autre élément enfichable (9, 4) à l'autre extrémité du câble au moyen d'un circuit de signalisation électrique (21, 22) dans le câble (3), et l'élément enfichable présentant un boîtier d'élément enfichable (16) doté d'une section de boîtier (20) avec au moins un émetteur de signal (5, 6), de façon à ce qu'au moins un émetteur de signal (5, 6) sur un élément enfichable soit activable à partir d'un autre élément enfichable lors de l'alimentation en énergie dans le circuit de signalisation électrique (21, 22), **caractérisé en ce que** une section de boîtier d'élément enfichable (20) est doté d'une languette de protection (17), l'émetteur de signal (5) est un émetteur de signal optoélectronique près de la languette de protection (17) et la languette de protection (17) avec le boîtier d'élément enfichable, au moins partiellement, sont configurés en vue de grossir la surface lumineuse de détection et, pour améliorer la détectabilité des éléments enfichables à l'extrémité du câble, soit de façon à conduire la lumière, soit transparents, opaques, opale ou fluorescents, et ont une connexion aux émetteurs de signal optoélectronique qui conduit à conduction optique partielle ou complète.

2. Câble (3) selon la revendication 1, **caractérisé en ce que** la section de boîtier (20) est pourvue d'au moins un contact électrique (18), auquel peut être raccordé de façon réversible une alimentation en courant externe (8), et qui peut être connecté, à l'intérieur du boîtier, de façon électrique à l'émetteur de signal (5, 6) d'un autre élément enfichable (4, 9).

3. Câble (3) selon la revendication 2, **caractérisé en ce que** les contacts conducteurs d'électricité (18) de l'élément enfichable (4, 9) sont raccordés de façon à conduire l'électricité, à l'intérieur du boîtier, avec le ou les émetteurs de signal (5, 6) de l'autre élément enfichable (4, 9) au moyen d'au moins un circuit de signalisation à l'intérieur du câble.

4. Câble (3) selon l'une des revendications précédentes, **caractérisé en ce que** l'un des circuits de signalisation (7, 21, 22) est doté d'au moins un fil d'essai à l'intérieur du câble (21) ou d'un recouvrement de câble (22).

5. Câble (3) selon l'une des revendications précédentes, **caractérisé en ce que** les émetteurs de signal optoélectroniques (5, 6) sont choisis à partir d'un groupe composé de diodes lumineuses, diodes électroluminescentes (DEL) ou de diodes à luminescence desquels, lors de l'alimentation en courant dans la gamme visible de longueurs d'ondes, émanent des rayons infrarouges ou ultraviolents.

6. Câble (3) selon l'une des revendications précédentes, **caractérisé en ce que** à au moins un des éléments enfichables (4, 9) est intégré une source de courant/tension (12, 13) en vue de l'alimentation en énergie électrique à partir d'une source à l'intérieur du câble (12, 13) vers le circuit de signalisation électrique (21, 22).

7. Câble (3) selon la revendication 6, **caractérisé en ce que**, pour les sources d'énergies (12, 13) intégrées à l'élément enfichable (4, 9) et internes au câble, chaque élément enfichable (4, 9) comprend au moins un commutateur électrique (14, 15) intégré au circuit de courant.

8. Câble (3) selon la revendication 7, **caractérisé en ce que** les commutateurs d'élément enfichable (14, 15) sont choisis à partir d'un groupe composé de : boutons, boutons de blocage, commutateur magnétiques, commutateurs à relais, commutateurs à bascule, languettes à ressort ou autres dispositifs de languettes de protection à ressorts.

9. Câble (3) selon l'une des revendications précédentes, **caractérisé en ce que** l'alimentation en énergie vers le circuit de signalisation électrique (21, 22) est continuel ou cadencé.

10. Câble (3) selon l'une des revendications précédentes, **caractérisé en ce que** au moins un élément enfichable (4, 9) est une fiche ou douille au moins unipolaire pour le raccordement ou la connexion électrique du câble (3) à un câblage ou à un appareil ou à un dispositif de transmission de signaux.

11. Câble (3) selon l'une des revendications précédentes, **caractérisé en ce que** les sources d'énergies internes d'éléments enfichables (12, 13) sont sélectionnés parmi des piles, accumulateurs ou condensateurs.

12. Procédé d'identification d'éléments enfichables d'un circuit, **caractérisé par** :
- La disposition d'un câble selon l'une des revendications précédentes avec :
au moins un fil d'essai électrique;
au moins un élément d'affichage, sur un élément enfichable situé à l'extrémité du câble, qui est raccordé à une section opaque du boîtier de câble; et
au moins un élément d'activation, sur un élément enfichable situé à l'extrémité du câble, en vue de l'alimentation en énergie vers le circuit électrique;
- l'alimentation en énergie de l'élément d'affichage de l'élément de câble à identifier par l'alimentation en énergie du circuit d'essai électrique en passant par un élément d'activation après l'activation de l'affichage sur l'élément enfichable et sur une surface lumineuse du boîtier de la fiche; et
- l'identification des éléments enfichables du câble à l'aide de l'affichage.
